# EUROPEAN PATENT SPECIFICATION

(11) **EP 1 875 786 B1**
(45) Date of publication and mention of the grant of the patent: **15.02.2012**
(21) Application number: 05718798.1
(22) Date of filing: 25.04.2005
(51) Int. Cl.: H05K 1/02

(54) **METHOD AND SYSTEM OF HEAT CONDUCTOR**
VERFAHREN UND SYSTEM EINES WÄRMELEITERS
PROCEDE ET SYSTEME DE CONDUCTION THERMIQUE

(43) Date of publication of application: 09.01.2008
(73) Proprietor: Telefonaktiebolaget L- M Ericsson (publ), 164 83 Stockholm (SE)
(72) Inventor: TAGEMAN, Ola, S-41135 Göteborg (SE); LIGANDER, Per, S-41456 Göteborg (SE)
(74) Representative: Vejgaard, Christian
(86) International application number: PCT/IB2005/051338
(87) International publication number: WO 2006/114665

(56) References cited:
- WO-A1-99/52148
- US-B1- 6 765 798

## Description

### TECHNICAL FIELD OF THE INVENTION

The present invention relates to assembly of electronic equipment. More especially it relates to mounting of high frequency electronic components for efficient cooling. Particularly it relates to efficiently transporting heat and eliminating air gaps in microwave equipment.

### BACKGROUND AND DESCRIPTION OF RELATED ART

Mounting of flange type packages are known in the art. Flange type packages are known to have good thermal handling capability, but also to not self-align well during reflow soldering and to generally perform poorly at microwave frequencies. A reason to why they do not self-align well is that the restoring action due to surface tension around the solder/air periphery is small relative to the misaligning action caused by gravity and non-planarity/asymmetries. In order to stand the stress from mounting screws, flange type packages need to be robust which is difficult to achieve at reasonable costs combined with fine features and high precision. Self-alignment, fine features and high precision are critical for good microwave performance.

Packages with fine features, below referred to as fine feature packages, such as BGA (Ball Grid Array) and LGA (Land Grid Array), with many separated pads are known in the art. The thermal performance of these kinds of packages can be acceptable as regards heat transport from the active device to the bottom of the package.

Various circuit boards are also known in the art. FR4 (Flame Retardant 4) multilayer circuit boards represent one known example type of circuit boards. FR4 circuit boards are essential in almost all modern high volume electronic products. However, they are not particularly well adapted for efficient cooling and high mechanical precision.

Hard backed boards represent a type of circuit board adapted for efficient cooling and high mechanical precision, however they are available at a substantially higher price than FR4 circuit boards.

Another known method of achieving heat transport other than through the circuit board is adoption of a convective heat sink. This can be achieved by mounting of cooling flanges on circuit packages or by forcing convection by means of a fan.

Reflow soldering is a known method of soldering components onto a circuit board. Components are soldered onto a circuit board, which may include earlier soldered circuit boards or parts.

*U.S. Patent* US5019941 discloses an electronic assembly having enhanced heat-dissipating capabilities. Heat removal is accomplished by utilizing a first metal conductive pad to conduct the heat from an electrical component. The first pad is juxtaposed and thereby thermally coupled by convection to one or more ground pads having plated through holes to a ground plane and heat sink.

WO Internation application WO99/52148 discloses a thermally conductive mounting flange of an IC packaged, placed directly on a heat sink surface between respective sections of a single layer PC board attached to the heat sink.

Prior art does not reveal efficient solutions of heat transport away from a board on which a circuit package is mounted without reducing circuitry reliability, particularly it does not reveal heat conductors suitable for surface mounting featuring a thermal path through a board and eliminating or reducing gaps between board and heat sink on the bottom side of the board, rendering low-cost boards available for mounting of high frequency components and applications, e.g. microwave applications.

### SUMMARY OF THE INVENTION

A general problem of high frequency electronic equipment is achieving good thermal properties while preserving good electrical performance at reasonable costs and with great equipment reliability.

Flange type packages, generally, do not perform well electrically at high frequencies (at least not unless used in combination with expensive hard backed boards with milled cavities), while having good thermal properties.

Fine feature packages may perform well electrically at high frequencies but impose problems as regards heat transport.

Convective heat sink generally requires a fan to achieve desired level of heat transport.

FR4 circuit boards have cost advantages as compared to hard backed boards, while the latter outperforms the former as regards thermal properties.

Consequently, there is a need of efficiently providing method and means for heat transport and appropriate mounting on circuit boards, not introducing additional requirements on the boards, and preferably not on the packages to be mounted.

An object of the invention is to increase the thermal transport through a circuit board.

Another object is to provide a means for arranging heat transport not reducing circuitry reliability.

Further, it is an object to eliminate or reduce gaps between a circuit board and a heat sink, not requiring clamping means in the immediate vicinity of an electric component.

It is also an object to provide a means suitable for surface mounting and reflow soldering.

A further object is to provide a means for heat conduction along a circuit board suitable for automatic mounting.

Additionally, an object is to economically reduce thermal resistance from a heat source to a heat sink.

Finally, it is an object to provide a method of reliably assembling circuit board, heat conductor and heat sink.

These objects are met by method and means of heat conductor for surface mount assembly.

Preferred embodiments of the invention, by way of examples, are described with reference to the accompanying drawings below.

### BRIEF DESCRIPTION OF THE DRAWINGS

Figure 1 illustrates a side view of an example heat conductor, soldered to a circuit board according to the invention.
Figure 2 monitors a side view of an example heat conductor clamped to the circuit board according to the invention.
Figure 3 shows a top view of an example heat conductor according to the invention.
Figure 4 illustrates a schematic flowchart for mounting of an example heat conductor according to the invention.
Figure 5 depicts from above an example board with electronic components and heat conducting plates according to the invention.
Figure 6 shows a side view of the example board illustrated in figure 5 connected to a heat sink according to the invention.

### DESCRIPTION OF PREFERRED EMBODIMENTS

As described in the background, there are high frequency flange type packages available. However, they are comparatively expensive and not suitable for surface mount assembly. Further, they require a metal backed board with cavities, which increases costs additionally.

Fine feature packages can have sufficiently fine features and precision to perform well at microwave frequencies at relatively low costs. Even if the heat transport from the active device to the bottom of the package is at an acceptable level, the path through the board on which they are mounted has a much greater resistance than for the flange type package. Further, present solutions of leading heat through the board rely on vias with limited cross section area and there are also various restrictions on putting vias under the packages. A further problem of prior art solutions is that even if the heat is brought to the side of the board opposite to the side on which the package is mounted, the heat needs be transported to a heat sink. This is a true problem as when fixing the board to the heat sink gaps may occur between the board and the heat sink, unless the board is clamped to the heat sink. Such gaps contribute to undesired thermal resistance.

If screws are used to clamp the board to the heat sink, they cannot be put in the immediate vicinity of the package, since this would reduce reliability of the circuitry, e.g, there would be a risk of solder joint fractures and board bending.

Also, generally for fine feature packages the path through (through the board and into the heat sink) has generally much higher thermal resistance than for flange type packages.

A problem of convective heat sink as a solution to problems in prior art is that in order to give a significant improvement forced convection would be required.

Problems of FR4 circuit boards relate particularly to limited thermal conduction in the board and limited thermal conduction to a heat sink.

According to the invention a thermal path is added to the fine feature packages, thereby thermal properties are improved in relation to prior art solutions while preserving desired electrical properties. Also according to the invention, it is applicable for FR4 circuit boards and does not require hard backed boards as flange type packages normally do.

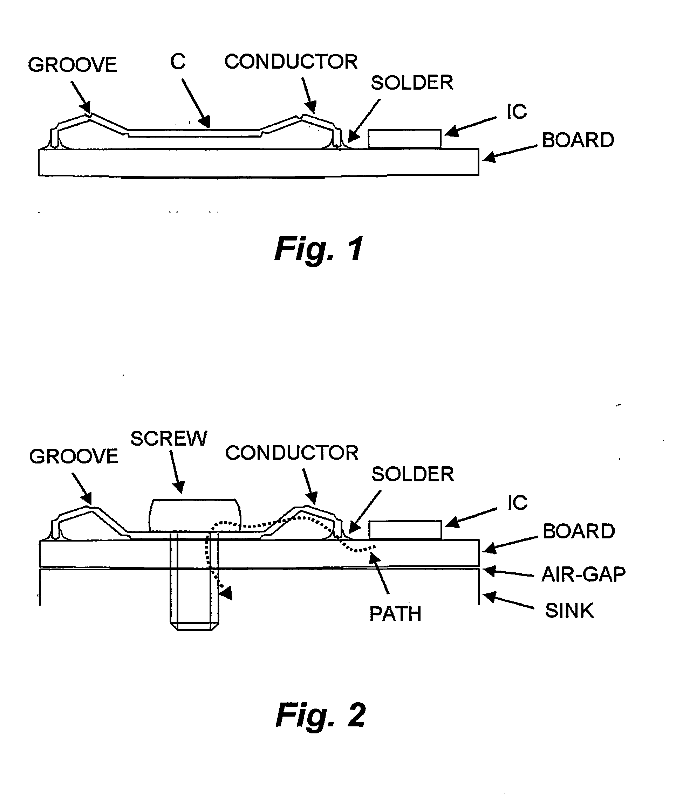

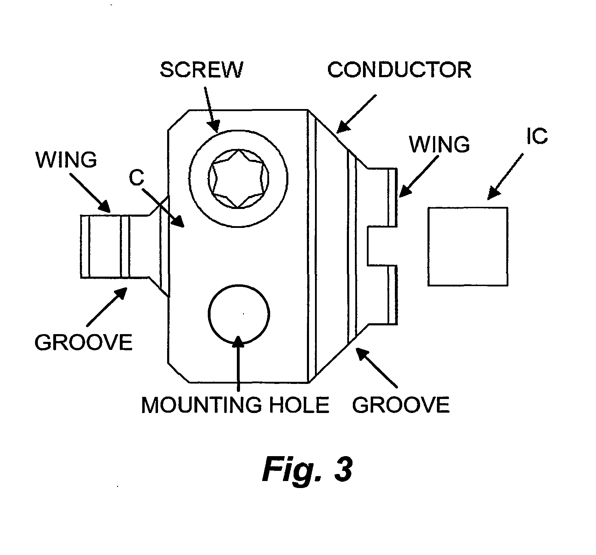

Figures 1 and 2 illustrate a side view, and figure 3 a top view, of an embodiment according to the invention. A heat conductor «CONDUCTOR» is shaped into a profile similar to that shown in figure 1 and plated with a surface finish suitable for soldering. Preferably it is provided for mounting as any other component in, e.g., T&R or on a tray. The heat conducting plate «CONDUCTOR» is formed with opposite legs to be soldered «SOLDER» to an essentially flat circuit board. Preferably the conductor has been preshaped such that when put onto a circuit board, as illustrated in figure 3, three soldering points are in contact with the circuit board. With only three points or legs in contact with the circuit board, it is guaranteed that all points or legs can be in contact with the board, even if the circuit board or conducting plate is skewed to some small extent. This cannot be guaranteed with more than three soldering points or legs. The pre-shaping is preferably such that there is a small gap between a central, and essentially flat, part «C» of the conducting plate «CONDUCTOR» and the circuit board. This gap is eliminated when one or more screws clamp conducting plate, circuit board and heat sink.

With reference to figure 1, according to a preferred mode of the invention a shaped heat conducting plate is soldered close to an electrical component «IC», e.g. an IC (Integrated Circuit), to be cooled. The heat conducting plate is soldered «SOLDER» to the circuit board «BOARD» close to the electrical component «IC». Preferably, the shaped heat conducting plate and the IC are surface mounted on the circuit board «BOARD». The amount of metal of the heat conducting plate and its thermal conductivity contributes to the heat transport. The use of a separate heat conducting plate also contributes to the invention being mechanically robust and reliable. The heat conducting plate is preferably formed such that the central part «C» of the heat conducting plate is separated a small distance, typically in the range of hundreds of micrometers.

With reference to figure 2, due to the shape of the plate and it being soldered along opposite sides of the plate «CONDUCTOR», the mechanical stress on the solder joints is relaxed and a central region of the plate «CONDUCTOR» can be clamped close to the circuit board «BOARD» without causing solder joint fractures. With at least one solder point an un-broken heat conducting path «PATH» is formed. Further, a preferred flat surface area at the center of gravity of the plate allows for automatic mounting, e.g. by means of vacuum nozzles.

With reference to figure 3, the heat conducting plate «CONDUCTOR» is preferably wing shaped «WING» to further reduce the mechanical stress while essentially preserving thermal properties. To further reduce the mechanical forces when the plate is pressed towards the board by the mounting screws, there are preferably one or more profiled or bent zones of the heat conducting plate. The one or more zones preferably comprise grooves «GROOVE», along which the heat conducting plate easily bends, e.g. when screws, bolts or corresponding devices «SCREW» through mounting holes «MOUNTING HOLE» are tightened, pressing the heat conducting plate «CONDUCTOR» towards the circuit board «BOARD», as illustrated in figure 2. To maximize flexibility the grooves are preferably arranged along parallel axes. The relaxed mechanical forces minimize the risk of the circuit board being bent during soldering and minimize the risk of solder joint fracture during and after the soldering operation. Also preferably, the heat conducting plate «CONDUCTOR» has more than one hole «MOUNTING HOLE» for mounting screws, bolts, or corresponding devices «SCREW». By mounting the heat conducting plate with more than one screw, bolt, or corresponding device, more than one screw can be mounted before tightening the screws, whereby the mechanical stress from torsion and shear stress on the solder joints is relaxed when fixing the circuit board and the heat conducting plate to a heat sink. Also, by use of multiple thermal paths through the board «BOARD» the thermal resistance is reduced. To further reduce thermal resistance, screws, bolts or corresponding devices «SCREW» are preferably made of metal with high thermal conductivity.

When fixed to the heat sink, the mounting screws, bolts or corresponding devices «SCREW» through the heat conducting plate will transport heat, as illustrated in figure 2 by a dashed arrow «PATH», from the press side of the screw heads «SCREW» to the heat sink «SINK», and the electrical component will be cooled. The one or more screws contribute to a low resistance path formed by the screws, or corresponding devices. The heat does not need to be transported to the sink by the board material. Due to the clamping force from the screws, there is no or negligible air gap «AIRGAP», which could deteriorate performance, between the layers formed by the heat conducting plate «CONDUCTOR», the circuit board «BOARD» and the heat sink «SINK» in the vicinity of the heat conducting plate and its mounting screws «SCREW», as illustrated in figure 2, and the dominating component of heat transport is due to the stress from the screws, bolts or corresponding devices.

An advantage of the invention is that it does not require thermal gap fillers, of e.g. thermal pads or thermal grease, to achieve low thermal resistance. The invention, however, does not exclude use of thermal gap fillers. Among the drawbacks are risk of contamination by thermal grease that leads to poor electrical contact or poor solder ability, risk of air entrapment, additional process steps of inserting thermal grease or thermal pads introducing extra processing time and cost, and cleaning and applying of new grease when rework is required. Gap fillers may also increase thermal resistance and require high mounting precision.

The heat conducting plate is preferably made of deformable or flexible metal with high thermal conductivity. The ease with which the heat conducting plate deforms, particularly along the grooves «GROOVE» and the extensions/wings «WING», allows the extensions/wings «WING» to adjust such that the center portion of the heat conductor approaches the board during screw mounting, as shown in figure 2.

The invention is particularly well suited for electrical components, e.g. ICs, that allow a good thermal connection from the semiconductor die of the integrated circuit to the side of the package. This can be achieved, e.g., with LGA packages, which have signal pads on only two sides.

Influence on positioning of an electrical component, irrespective of its reflow self alignment, from a heat conducting plate arrangement according to the invention can be eliminated by ensuring that solder from the pads for wing of heat conducting plate and package, respectively, will not come into contact. This can be ensured, e.g., by putting a line of solder-stop separating the pads. Thereby a continuous copper plane can be used for maximum heat conduction.

Among the advantages of the invention are, as intimated above, improved thermal performance without degraded electrical performance in microwave frequency range and without adding new requirements on the circuit board or on the soldering process.

When mounting onto a heat sink «SINK» it has also been mentioned above the preference of installing more than one screw «SCREW» into the heat conducting plate «CONDUCTOR» prior to tightening the screws.

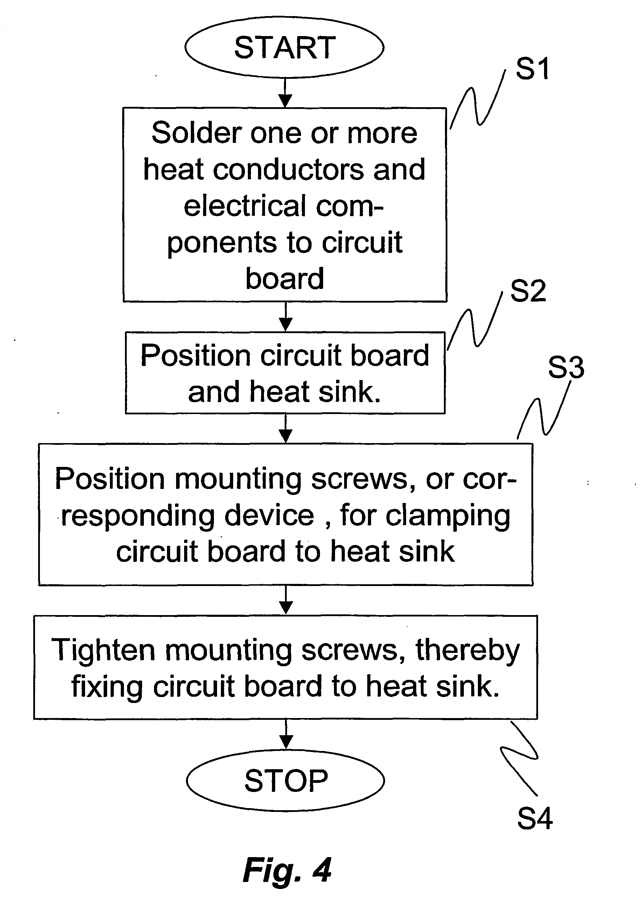

Mounting is preferably performed in two or more steps, schematically illustrated in figure 4. The preferred steps include soldering of the heat conducting plate to the circuit board «S1». Electrical components are preferably mounted in the same reflow process «S1» as the heat conducting plates. They can also be soldered in a second reflow process, before or after soldering of the heat conducting plates. Mounting the circuit board to a chassis/heat sink, is preferably performed in one step, however illustrated in three distinct steps «S2», «S3», «S4» in figure 4 for reasons of clarity. One or more circuit boards with mounted components and one or more heat conducting plates are positioned in relation to mounting holes on heat sink, and possibly also to a chassis where it is installed «S2». Mounting screws or corresponding devices are positioned, and possibly loosely tightened in more than one hole of each heat conducting plate according to the invention «S3». Preferably all mounting screws are positioned prior to tightening the screws «S4», thereby fixing the heat conducting plate, the circuit board and the heat sink. When essentially simultaneously mounting the board in a chassis also screws holding the circuit board to the chassis are tightened.

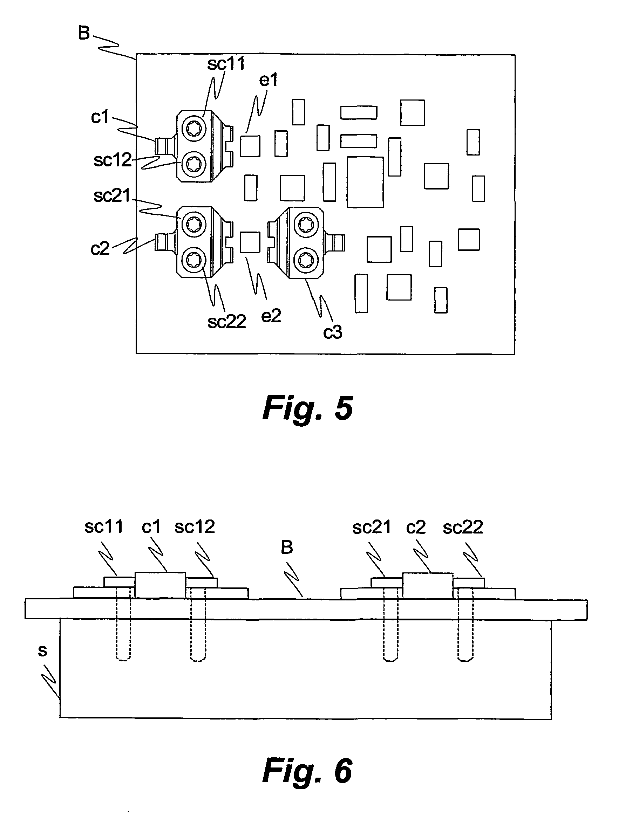

Figure 5 illustrates a top view of an example board with electronic components «e1», «e2» and heat conducting plates «c1» «c2», «c3» positioned in the vicinity of components «e1» and «e2» and mounted as described above. In the figure is illustrated for the example board that one conducting plate «c1» is arranged for conducting heat from an electronic component «e1» and more than one conducting plate «c2», «c3» are arranged for conducting heat from an electronic component «e2». In order to maximize cooling, each heat conducting plate «c1» «c2», «c3», is positioned with two of their preferably three legs facing the electrical component «e1», «e2» to be cooled primarily. When more than one heat conductor can be put around a package, the thermal resistance is further reduced. With both legs soldered to the board two un-broken heat conducting paths are formed thereby approximately halving the thermal resistance related to each plate. The illustrated heat conducting plates «c1», «c2», «c3» comprise extensions/wings, in preferred more than one direction, in order to maximize cooling. Each mounting plate in the example realization is illustrated mounted with two screws «sc11», «sc12», «sc21», «sc22».

Figure 6 illustrates a side view of the example board according to the invention illustrated in figure 5 with heat sink «s» to which the heat conducting plates «c1», «c2» and the board «B» are clamped by screws, bolts or corresponding devices «sc11», «sc12», «sc21», «sc22».

In this patent application acronyms such as FR4, BGA, LGA and IC are applied. However, the invention is not limited to equipment with entities with these acronyms, but holds for all equipment similar in nature.

The invention is not intended to be limited only to the embodiments described in detail above. Changes and modifications may be made without departing from the invention. It covers all modifications within the scope of the following claims.

## Claims

1. A system comprising a circuit board (BOARD), one or more high frequency electronic components (IC, e1, e2)and heat conductor means made of heat conducting material, the heat conductor means comprising at least one mounting hole;
the circuit board comprising at least one hole corresponding to the at least one mounting hole of the heat conductor means; and
a mounting screw (SCREW, sc11, sc12, sc21, sc22) or a bolt for mounting, through the at least one mounting hole (MOUNTING HOLE)of the heat conductor means and the at least one corresponding hole of the circuit board, the mounting screw or bolt being fastened in a heat sink (SINK)on a side of the circuit board being opposite to the heat conductor means, thereby clamping the heat conductor means and the circuit board towards the heat sink; the system **characterized** b y the heat conductor means comprising at least one leg, at least one groove (GROOVE)along a direction across a direction parallel to an elongation of the at least one leg the heat conductor means capable of being bent flexibly along a direction across a direction parallel to an elongation of the leg; one or more regions of said heat conductor means being profiled or bent said means being bent along the at least one groove (GROOVE); and the electronic components (IC, e1, e2)and the heat conductor means being surface mounted on the circuit board.

2. The system according to claim 1 **characterized by** the conductor means being mounted on a continuous heat conductor on which an electronic component (IC, e1, e2) is mounted.

3. The system according to claim 1 **characterized by** the at least one groove (GROOVE) being perpendicular to a line parallel with an elongation of the at least one leg.

4. The system according to claim 1 **characterized by** at least two of the at least one groove (GROOVE) being parallel.

5. The system according to claim 1 **characterized by** the heat conductor means being arranged for strain relief in the solder joints and circuit board.

6. The heat conductor means according to claim 1 **characterized by** the heat conductor means, comprising a central flat area (C).

7. The system according to claim 1 **characterized by** the heat conductor means comprising three or less legs.

8. The system according to claim 1 **characterized by** the heat conductor means being soldered to the circuit board (BOARD) at the at least one leg.

9. The system according to claim 1 **characterized by** the heat conductor means being soldered to the circuit board at two solder points proximate to an electrical component.

10. The system according to claim 8 **characterized by** the heat conductor means being soldered to the circuit board (BOARD)at two or three solder points.

11. The system according to claim 1 **characterized by** the heat conductor means comprising metal extensions from a central metal plate.

12. The system according to claim 11 **characterized by** the heat conductor means arranged for one or more extensions bending flexibly along grooves.

13. A method of assembling a system comprising a circuit board, one or more electronic components and one or more heat conductor means of heat conducting material, comprising at least one leg and at least one groove (GROOVE)along a direction across a direction parallel to an elongation of the at least one leg the method **characterized by** the steps of:
soldering (S1) of at least one leg of each of the one or more heat conductor means being bent along a direction across a direction parallel to an elongation of the at least one leg and being bent along one or more grooves (GROOVE) in a direction across a direction parallel to an elongation of the at least one leg.
positioning (S2) one or more heat conductor means on the circuit board (BOARD);
positioning and loosely fixing (S3)one or more screws through holes of the one or more heat conductor means, the circuit board and a heat sink;
tightening (S4) the one or more screws thereby clamping the heat conductor means, the circuit board and the heat sink
and in that the **method** of assembling comprises surface mounting.

14. The method according to claim 13 **characterized by** the step of positioning the one or more heat conductor means comprising positioning the one or more heat conductor means by use of one or more vacuum nozzles.

15. The method according to claim 13 **characterized by** the step of soldering comprising the one or more heat conductor means being soldered in a same solder cycle as the electronic components (IC, e1, e2).

16. The method according to claim 13 or 15 **characterized by** the conductor means being mounted on a continuous heat conductor on which an electronic component (IC, e1, e2)is being mounted.

17. The method according to claim 13 or 15 **characterized by** the conductor means and an electronic component (IC, e1, e2) being mounted separated by solder stop.

18. The method according to claim 13 **characterized by** the heat conductor means being arranged for strain relief in the solder joints and circuit board (BOARD).

19. The method according to claim 13 **characterized by** the heat conductor means being bent flexibly along the grooves (GROOVE).

20. The method according to claim 13 **characterized by** the heat conductor means comprising grooves (GROOVE)in direction across a direction parallel to an elongation of the at least one leg.

21. The method according to claim 20 **characterized by** the heat conductor means comprising grooves (GROOVE)in direction across a direction parallel to an elongation of the at least one leg.

22. The method according to claim 13 **characterized in that** the heat conductor means being bent along one or more grooves (GROOVE) perpendicular to the at least one leg.

23. The method according to claim 13 **characterized in that** heat conductor means comprising two or more parallel grooves (GROOVE).

24. The method according to claim 13 **characterized by** the heat conductor means being soldered to the circuit board (BOARD)at three or less solder points.

25. The method according to claim 13 **characterized by** the heat conductor means being soldered to the circuit board (BOARD)at two solder points proximate to an electrical component (IC, e1, e2).

26. The method according to claim 13 **characterized by** the step of positioning one or more screws (SCREW, sc11 sc12, sc21, sc22) comprising positioning at least two screws for each of the one or more heat conductor means prior to tightening the screws.

27. A heat conductor made of heat conducting material for mounting on circuit boards, comprising at least one mounting hole, the heat conductor **characterized by**
at least one leg, the heat conductor bending flexibly along a direction across a direction parallel to an elongation of the at least one leg and;
at least one groove (GROOVE)in direction across a direction parallel to an elongation of the at least one leg, said heat heat conductor means being capable of being bent along the at least one groove (Groove).

28. The heat conductor according to claim 27 **characterized by** the heat conductor comprising at least two mounting holes (MOUNTING HOLE).

29. The heat conductor according to claim 27 **characterized by** the heat conductor comprising a flat surface (C) with no holes at the center of gravity of the heat conductor.

30. The heat conductor according to claim 27 **characterized by** the heat conductor means being arranged for strain relief in the solder joints and circuit board.

31. The heat conductor according to claim 27 **characterized by** the heat conductor means comprising three or less legs.

32. The heat conductor according to claim 27 **characterized by** the heat conductor comprising a central flat area (C).

## Patentansprüche

1. System, umfassend eine Leiterplatte (BOARD), ein oder mehrere elektronische Hochfrequenzbauelemente (IC, e1, e2) und ein Wärmeleitermittel, das aus wärmeleitendem Material hergestellt ist, wobei das Wärmeleitermittel mindestens ein Montageloch umfasst,
wobei die Leiterplatte mindestens ein dem mindestens einem Montageloch des Wärmeleitermittels entsprechendes Loch aufweist; und
eine Montageschraube (SCREW, sc1 sc12, sec21, sc22) oder einen Bolzen zum Montieren durch das mindestens eine Montageloch (MOUNTING HOLE) des Wärmeleitermittels und das mindestens eine entsprechende Loch der Leiterplatte hindurch, wobei die Montageschraube oder der Bolzen in einer Wärmesenke (SINK) auf einer Seite der Leiterplatte, die dem Wärmeleitermittel gegenüberliegt, festgezogen wird, wodurch das Wärmeleitermittel und die Leiterplatte an der Wärmesenke festgespannt werden;
wobei das System **dadurch gekennzeichnet ist, dass** das Wärmeleitermittel mindestens ein Bein und mindestens eine Rille (GROOVE) entlang einer Richtung quer zu einer Richtung parallel zu einer Verlängerung des mindestens einen Beins umfasst, wobei das Wärmeleitermittel imstande ist, flexibel entlang einer Richtung quer zu einer Richtung parallel zu einer Verlängerung des Beins gebogen zu werden, wobei ein oder mehrere Bereiche des Wärmeleitermittels profiliert oder gebogen sind, wobei das Mittel entlang der mindestens einen Rille (GROOVE) gebogen wird, und die elektronischen Bauelemente (IC, e1, e2) und das Wärmeleitermittel auf der Leiterplatte oberflächenmontiert werden.

2. System nach Anspruch 1, **dadurch gekennzeichnet, dass** das Wärmeleitermittel auf einem durchgehenden Wärmeleiter montiert wird, auf dem ein elektronisches Bauelement (IC, e1, e2) montiert wird.

3. System nach Anspruch 1, **dadurch gekennzeichnet, dass** die mindestens eine Rille (GROOVE) senkrecht zu einer Linie verläuft, die parallel zu einer Verlängerung des mindestens einen Beins ist.

4. System nach Anspruch 1, **dadurch gekennzeichnet, dass** mindestens zwei der mindestens einen Rille (GROOVE) parallel sind.

5. System nach Anspruch 1, **dadurch gekennzeichnet, dass** das Wärmeleitermittel zur Zugentlastung in den Lötpunkten und der Leiterplatte angeordnet ist.

6. System nach Anspruch 1, **dadurch gekennzeichnet, dass** das Wärmeleitermittel einen zentralen flachen Bereich (C) umfasst.

7. System nach Anspruch 1, **dadurch gekennzeichnet, dass** das Wärmeleitermittel drei oder weniger Beine umfasst.

8. System nach Anspruch 1, **dadurch gekennzeichnet, dass** das Wärmeleitermittel an dem mindestens einen Bein auf die Leiterplatte (BOARD) gelötet ist.

9. System nach Anspruch 1, **dadurch gekennzeichnet, dass** das Wärmeleitermittel an zwei Lötpunkten in unmittelbarer Nähe eines elektrischen Bauelements auf die Leiterplatte gelötet ist.

10. System nach Anspruch 8, **dadurch gekennzeichnet, dass** das Wärmeleitermittel an zwei oder drei Lötpunkten auf die Leiterplatte (BOARD) gelötet ist.

11. System nach Anspruch 1, **dadurch gekennzeichnet, dass** das Wärmeleitermittel Metallverlängerungen von einer zentralen Metallplatte umfasst.

12. System nach Anspruch 1, **dadurch gekennzeichnet, dass** das Wärmeleitermittel dafür eingerichtet ist, dass eine oder mehrere Verlängerungen flexibel entlang von Rillen gebogen werden.

13. Verfahren zum Zusammensetzen eines Systems, welches umfasst: eine Leiterplatte, ein oder mehrere elektronische Bauelemente und ein oder mehrere Wärmeleitermittel aus wärmeleitendem Material, das bzw. die mindestens ein Bein und mindestens eine Rille (GROOVE) entlang einer Richtung quer zu einer Richtung parallel zu einer Verlängerung des mindestens einen Beins umfasst bzw. umfassen; wobei das Verfahren durch die folgenden Schritte gekennzeichnet ist:
Löten (S1) mindestens eines Beins jedes des einen oder der mehreren Wärmeleitermittel, das entlang einer Richtung quer zu einer Richtung parallel zu einer Verlängerung des mindestens einen Beins gebogen wird, wobei es entlang einer oder mehrerer Rillen (GROOVE) in einer Richtung quer zu einer Richtung parallel zu einer Verlängerung des mindestens einen Beins gebogen wird;
Positionieren (S2) eines oder mehrerer Wärmeleitermittel auf der Leiterplatte (BOARD);
Positionieren und lockeres Fixieren (S3) einer oder mehrerer Schrauben durch Löcher des einen oder der mehreren Wärmeleitermittel, der Leiterplatte und einer Wärmesenke;
Festziehen (S4) der einen oder mehreren Schrauben, wodurch das Wärmeleitermittel, die Leiterplatte und die Wärmesenke festgespannt werden,
und dadurch, dass das Verfahren zum Zusammensetzen eine Oberflächenmontage umfasst.

14. Verfahren nach Anspruch 13, **dadurch gekennzeichnet, dass** der Schritt des Positionierens des einen oder der mehreren Wärmeleitermittel umfasst: Positionieren des einen oder der mehreren Wärmeleitermittel mittels einer oder mehrerer Saugdüsen.

15. Verfahren nach Anspruch 13, **dadurch gekennzeichnet, dass** der Schritt des Lötens umfasst, dass das eine oder die mehreren Wärmeleitermittel im gleichen Lötzyklus wie die elektronischen Bauelemente (IC, e1, e2) gelötet werden.

16. Verfahren nach Anspruch 13 oder 15, **dadurch gekennzeichnet, dass** das Wärmeleitermittel auf einem durchgehenden Wärmeleiter montiert wird, auf dem ein elektronisches Bauelement (IC, e1, e2) montiert wird.

17. Verfahren nach Anspruch 13 oder 15, **dadurch gekennzeichnet, dass** das Wärmeleitermittel und ein elektronisches Bauelement (IC, e1, e2) durch Lötstopplack getrennt montiert werden.

18. Verfahren nach Anspruch 13, **dadurch gekennzeichnet, dass** das Wärmeleitermittel zur Zugentlastung in den Lötpunkten und der Leiterplatte (BOARD) angeordnet wird.

19. Verfahren nach Anspruch 13, **dadurch gekennzeichnet, dass** das Wärmeleitermittel flexibel entlang der Rillen (GROOVE) gebogen wird.

20. Verfahren nach Anspruch 13, **dadurch gekennzeichnet, dass** das Wärmeleitermittel Rillen (GROOVE) in einer Richtung quer zu einer Richtung parallel zu einer Verlängerung des mindestens einen Beins umfasst.

21. Verfahren nach Anspruch 20 **dadurch gekennzeichnet, dass** das Wärmeleitermittel Rillen (GROOVE) in einer Richtung quer zu einer Richtung parallel zu einer Verlängerung des mindestens einen Beins umfasst.

22. Verfahren nach Anspruch 13, **dadurch gekennzeichnet, dass** das Wärmeleitermittel entlang einer oder mehrerer paralleler Rillen (GROOVE) senkrecht zu dem mindestens einen Bein gebogen wird.

23. Verfahren nach Anspruch 13, **dadurch gekennzeichnet, dass** das Wärmeleitermittel zwei oder mehrere parallele Rillen (GROOVE) umfasst.

24. Verfahren nach Anspruch 13, **dadurch gekennzeichnet, dass** das Wärmeleitermittel an drei oder weniger Lötpunkten auf die Leiterplatte (BOARD) gelötet wird.

25. Verfahren nach Anspruch 13, **dadurch gekennzeichnet, dass** das Wärmeleitermittel an zwei Lötpunkten in unmittelbarer Nähe eines elektrischen Bauelements (IC, e1, e2) auf die Leiterplatte (BAORD) gelötet wird.

26. Verfahren nach Anspruch 13, **dadurch gekennzeichnet, dass** der Schritt des Positionierens einer oder mehrerer Schrauben (SCREW, sc11, sc12, sc21, sc22) umfasst:
Positionieren mindestens zweier Schrauben für jedes des einen oder der mehreren Wärmeleitermittel vor dem Festziehen der Schrauben.

27. Wärmeleiter, hergestellt aus wärmeleitendem Material, zum Montieren auf Leiterplatten, umfassend mindestens ein Montageloch, wobei der Wärmeleiter **gekennzeichnet ist durch**:
mindestens ein Bein, wobei der Wärmeleiter flexibel entlang einer Richtung quer zu einer Richtung parallel zu einer Verlängerung des mindestens einen Beins gebogen wird; und
mindestens eine Rille (GROOVE) in einer Richtung quer zu einer Richtung parallel zu einer Verlängerung des mindestens einen Beins, wobei der Wärmeleiter imstande ist, entlang der mindestens einen Rille (GROOVE) gebogen zu werden.

28. Wärmeleiter nach Anspruch 27, **dadurch gekennzeichnet, dass** der Wärmeleiter mindestens zwei Montagelöcher (MOUNTING HOLE) umfasst.

29. Wärmeleiter nach Anspruch 27, **dadurch gekennzeichnet, dass** der Wärmeleiter eine flache Oberfläche (C) ohne Löcher im Schwerpunkt des Wärmeleiters umfasst.

30. Wärmeleiter nach Anspruch 27, **dadurch gekennzeichnet, dass** der Wärmeleiter zur Zugentlastung in den Lötpunkten und der Leiterplatte angeordnet ist.

31. Wärmeleiter nach Anspruch 27, **dadurch gekennzeichnet, dass** der Wärmeleiter drei oder weniger Beine umfasst.

32. Wärmeleiter nach Anspruch 27, **dadurch gekennzeichnet, dass** der Wärmeleiter einen zentralen flachen Bereich (C) umfasst.

## Revendications

1. Système comprenant une carte de circuit (BOARD), un ou plusieurs composants électroniques haute fréquence (IC, e1, e2) et des moyens thermo-conducteurs constitués d'un matériau thermo-conducteur, les moyens thermo-conducteurs comprenant au moins un trou de montage ;
la carte de circuit comprenant au moins un trou correspondant audit au moins un trou de montage des moyens thermo-conducteurs ; et
une vis de montage (SCREW, sc11, sc12, sc21, sc22) ou un boulon destiné à être monté à travers ledit au moins un trou de montage (MOUNTING HOLE) des moyens thermo-conducteurs et ledit au moins un trou correspondant de la carte de circuit, la vis de montage ou le boulon étant fixé dans un dissipateur de chaleur (SINK) d'un côté de la carte de circuit à l'opposé desdits moyens thermo-conducteurs, serrant de ce fait les moyens thermo-conducteurs et la carte de circuit vers le dissipateur de chaleur ;
le système étant **caractérisé en ce que** les moyens thermo-conducteurs comprennent au moins une branche et au moins une rainure (GROOVE) le long d'une direction transversale à une direction parallèle à une extension de ladite au moins une branche, les moyens thermo-conducteurs peuvent être pliés de manière souple le long d'une direction transversale à une direction parallèle à une extension de la branche ; une ou plusieurs régions desdits moyens thermo-conducteurs sont profilées ou pliées, lesdits moyens étant pliés le long de ladite au moins une rainure (GROOVE) ; et les composants électroniques (IC, e1, e2) et les moyens thermo-conducteurs sont montés en surface sur la carte de circuit.

2. Système selon la revendication 1, **caractérisé en ce que** les moyens conducteurs sont montés sur un conducteur thermique continu sur lequel un composant électronique (IC, e1, e2) est monté.

3. Système selon la revendication 1, **caractérisé en ce que** ladite au moins une rainure (GROOVE) est perpendiculaire à une ligne parallèle à une extension de ladite au moins une branche.

4. Système selon la revendication 1, **caractérisé en ce qu'**au moins deux de ladite au moins une rainure (GROOVE) sont parallèles.

5. Système selon la revendication 1, **caractérisé en ce que** les moyens thermo-conducteurs sont agencés pour une réduction des contraintes dans les joints de soudure et la carte de circuit.

6. Moyens thermo-conducteurs selon la revendication 1, **caractérisés en ce que** les moyens thermo-conducteurs comprennent une zone centrale plate (C).

7. Système selon la revendication 1, **caractérisé en ce que** les moyens thermo-conducteurs comprennent trois branches ou moins.

8. Système selon la revendication 1, **caractérisé en ce que** les moyens thermo-conducteurs sont soudés à la carte de circuit (BOARD) au niveau de ladite au moins une branche.

9. Système selon la revendication 1, **caractérisé en ce que** les moyens thermo-conducteurs sont soudés à la carte de circuit au niveau de deux points de soudure à proximité d'un composant électrique.

10. Système selon la revendication 8, **caractérisé en ce que** les moyens thermo-conducteurs sont soudés à la carte de circuit (BOARD) au niveau de deux ou trois points de soudure.

11. Système selon la revendication 1, **caractérisé en ce que** les moyens thermo-conducteurs comprennent des extensions métalliques d'une plaque métallique centrale.

12. Système selon la revendication 11, **caractérisé en ce que** les moyens thermo-conducteurs sont agencés pour qu'une ou plusieurs extensions se plient souplement le long de rainures.

13. Procédé d'assemblage d'un système comprenant une carte de circuit, un ou plusieurs composants électroniques et un ou plusieurs moyens thermo-conducteurs constitués d'un matériau thermo-conducteur comprenant au moins une branche et au moins une rainure (GROOVE) le long d'une direction transversale à une direction parallèle à une extension de ladite au moins une branche, le procédé étant **caractérisé par** les étapes consistant à :
souder (S1) au moins une branche de chacun desdits un ou plusieurs moyens thermo-conducteurs qui sont pliés le long d'une direction transversale à une direction parallèle à une extension de ladite au moins une branche, et qui sont pliés le long d'une ou de plusieurs rainures (GROOVE) dans une direction transversale à une direction parallèle à une extension de ladite au moins une branche ;
positionner (S2) un ou plusieurs moyens thermo-conducteurs sur la carte de circuit (BOARD) ;
positionner et fixer sans serrage (S3) une ou plusieurs vis à travers les trous desdits un ou plusieurs moyens thermo-conducteurs, de la carte de circuit et d'un dissipateur de chaleur ;
serrer (S4) lesdites une ou plusieurs vis, serrant de ce fait les moyens thermo-conducteurs, la carte de circuit et le dissipateur de chaleur,
et en ce que le procédé d'assemblage comprend un montage en surface.

14. Procédé selon la revendication 13, **caractérisé en ce que** l'étape de positionnement desdits un ou plusieurs moyens thermo-conducteurs comprend le positionnement desdits un ou plusieurs moyens thermo-conducteurs en utilisant une ou plusieurs buses d'aspiration.

15. Procédé selon la revendication 13, **caractérisé en ce que** l'étape de soudage comprend le soudage desdits un ou plusieurs moyens thermo-conducteurs dans un même cycle de soudage que les composants électroniques (IC, e1, e2).

16. Procédé selon la revendication 13 ou 15, **caractérisé en ce que** les moyens conducteurs sont montés sur un conducteur thermique continu sur lequel un composant électronique (IC, e1, e2) est monté.

17. Procédé selon la revendication 13 ou 15, **caractérisé en ce que** les moyens conducteurs et un composant électronique (IC, e1, e2) sont montés séparés par une butée de soudure.

18. Procédé selon la revendication 13, **caractérisé en ce que** les moyens thermo-conducteurs sont agencés pour une réduction des contraintes dans les joints de soudure et la carte de circuit (BOARD).

19. Procédé selon la revendication 13, **caractérisé en ce que** les moyens thermo-conducteurs sont pliés de manière souple le long des rainures (GROOVE).

20. Procédé selon la revendication 13, **caractérisé en ce que** les moyens thermo-conducteurs comprennent des rainures (GROOVE) dans une direction transversale à une direction parallèle à une extension de ladite au moins une branche.

21. Procédé selon la revendication 20, **caractérisé en ce que** les moyens thermo-conducteurs comprennent des rainures (GROOVE) dans une direction transversale à une direction parallèle à une extension de ladite au moins une branche.

22. Procédé selon la revendication 13, **caractérisé en ce que** les moyens thermo-conducteurs sont pliés le long d'une ou de plusieurs rainures (GROOVE) perpendiculaires à ladite au moins une branche.

23. Procédé selon la revendication 13, **caractérisé en ce que** les moyens thermo-conducteurs comprennent deux rainures (GROOVE) parallèles ou plus.

24. Procédé selon la revendication 13, **caractérisé en ce que** les moyens thermo-conducteurs sont soudés à la carte de circuit (BOARD) au niveau de trois points de soudure ou moins.

25. Procédé selon la revendication 13, **caractérisé en ce que** les moyens thermo-conducteurs sont soudés à la carte de circuit (BOARD) au niveau de deux points de soudure à proximité d'un composant électrique (IC, e1, e2).

26. Procédé selon la revendication 13, **caractérisé en ce que** l'étape de positionnement d'une ou de plusieurs vis (SCREW, sc11 sc12, sc21, sc22) comprend le positionnement d'au moins deux vis pour chacun desdits un ou plusieurs moyens thermo-conducteurs avant le serrage des vis.

27. Conducteur thermique constitué d'un matériau thermo-conducteur destiné à être monté sur des cartes de circuit, comprenant au moins un trou de montage, le conducteur thermique étant **caractérisé par**
au moins une branche, le conducteur thermique étant plié souplement le long d'une direction transversale à une direction parallèle à une extension de ladite au moins une branche, et
au moins une rainure (GROOVE) dans une direction transversale à une direction parallèle à une extension de ladite au moins une branche, lesdits moyens thermo-conducteurs pouvant être pliés le long de ladite au moins une rainure (GROOVE).

28. Conducteur thermique selon la revendication 27, **caractérisé en ce que** le conducteur thermique comprend au moins deux trous de montage (MOUNTING HOLE).

29. Conducteur thermique selon la revendication 27, **caractérisé en ce que** le conducteur thermique comprend une surface plate (C) sans trous au niveau du centre de gravité du conducteur thermique.

30. Conducteur thermique selon la revendication 27, **caractérisé en ce que** les moyens thermo-conducteurs sont agencés pour une réduction des contraintes dans les joints de soudure et la carte de circuit.

31. Conducteur thermique selon la revendication 27, **caractérisé en ce que** les moyens thermo-conducteurs comprennent trois branches ou moins.

32. Conducteur thermique selon la revendication 27, **caractérisé en ce que** le conducteur thermique comprend une zone centrale plate (C).
